# EUROPÄISCHE PATENTANMELDUNG

(11) **EP 1 780 419 A2**
(43) Veröffentlichungstag der Anmeldung: **02.05.2007**
(21) Anmeldenummer: 06022516.6
(22) Anmeldetag: 27.10.2006
(51) Int. Cl.: F04D 29/66

(54) **Lüfteranordnung**

(30) Priorität: 28.10.2005 DE 102005051853; 05.04.2006 DE 202006005544 U
(71) Anmelder: Fujitsu Siemens Computers GmbH, 80807 München (DE)
(72) Erfinder: Götzfried, Manfred J.-W., 86343 Königsbrunn (DE)
(74) Vertreter: Epping - Hermann - Fischer

(57) **Zusammenfassung**

Die Erfindung betrifft eine Lüfteranordnung (1, 16), aufweisend ein Gehäuseteil (2), wenigstens einen Lüfter (3) und wenigstens ein Dämpfungselement (5) bestehend aus einem elastischen Material, wobei das Dämpfungselement (5) eine zentrale Öffnung (8) zur Befestigung des Dämpfungselementes (5) an Befestigungsöffnungen (7) des Lüfters (3) oder des Gehäuseteils (2) aufweist. Die Lüfteranordnung ist dadurch gekennzeichnet, dass das Dämpfungselement (5) Aussparungen (10) in einem Zwischenbereich (9) zwischen der zentralen Öffnung (8) und einem Randbereich (11) des Dämpfungselementes (5) zur Erhöhung der Verformbarkeit in sowohl axialer als auch radialer Richtung aufweist, um die Schwingungsübertragung von dem Lüfter (3) zu dem Gehäuseteil (2) zu dämpfen.

## Beschreibung

Die Erfindung betrifft eine Lüfteranordnung, aufweisend ein Gehäuseteil, wenigstens einen Lüfter und wenigstens ein Dämpfungselement bestehend aus einem elastischen Material, wobei das Dämpfungselement eine zentrale Öffnung zur Befestigung des Dämpfungselementes an Befestigungsöffnungen des Lüfters oder des Gehäuseteils aufweist.

Lüfteranordnungen mit Dämpfungselementen sind vielfach bekannt. Dabei dient das Dämpfungselement zur Verringerung der Schwingungsübertragung von einem Lüfter zu einem Gehäuseteil, um die Geräuschentwicklung durch die von dem Lüfter verursachten mechanischen Schwingungen zu reduzieren.

Aus der DE 201 20 225 U1 ist bekannt, einen Lüfter mittels mehrerer gummielastischer verbindungsschäfte mit einem Gehäuseteil zu verbinden. Dadurch ergibt sich eine schwingungsdämpfende Verbindung. Da der Lüfter dabei direkt durch die verbindungsschäfte gehalten wird, ist zum einen das Gewicht des Lüfters begrenzt, zum anderen müssen die Verbindungsschäfte relativ hart ausgeführt sein.

Aus der DE 203 20 813 U1 ist ein einteiliges Dämpfungselement bekannt, das zwischen einem Lüfter und einem Gehäuseteil angeordnet ist. Dadurch ergibt sich der Vorteil, dass die Montage des Dämpfungselements vereinfacht ist, insbesondere weil einzelne Halteelemente nicht mehr so leicht verloren gehen können. Jedoch ergibt sich auch hier das Problem, dass nur verhältnismäßig leichte Lüfter montiert werden können und das Gewicht des Lüfters die Elastizität des Dämpfungselementes bestimmt.

Durch die Entwicklung immer leistungsfähigerer Prozessoren besteht insbesondere im Serverbereich ein Bedarf für Lüfteranordnungen, die auch bei leistungsstarken und schnell drehenden Lüftern eine sichere, einfache, kostengünstige und schwingungsdämpfende Halterung ermöglichen. Aufgabe der Erfindung ist es daher, eine besonders einfache Lüfteranordnung zu beschreiben, die die Schwingungsübertragung von einem Lüfter zu einem Gehäuseteil weiter verringert.

Die Aufgabe wird durch eine Lüfteranordnung der eingangs genannten Art gelöst, die dadurch gekennzeichnet ist, dass das Dämpfungselement Aussparungen in einem Zwischenbereich zwischen der zentralen Öffnung und einem Randbereich des Dämpfungselementes zur Erhöhung der Verformbarkeit in sowohl axialer als auch radialer Richtung aufweist, um die Schwingungsübertragung von dem Lüfter zu dem Gehäuseteil zu dämpfen.

Mit Hilfe der zentralen Öffnung kann das Dämpfungselement sicher an dem Lüfter oder dem Gehäuseteil gehalten werden, beispielsweise durch Verwendung einer Schraube, eines Spreizniets oder eines an den Lüfter oder das Gehäuseteil angeflanschten Verbindungselementes. Die zusätzlichen Aussparungen in dem Körper des Dämpfungselementes erhöhen dessen Verformbarkeit und sorgen somit für eine bessere Dämpfung in axialer und radialer Richtung.

In einer bevorzugten Ausgestaltung weist das Dämpfungselement in einem Randbereich eine umlaufende Nut auf, durch die das Dämpfungselement in Aussparungen des Gehäuseteils eingepasst werden kann. Durch nachträgliches Verschrauben des Dämpfungselementes mit einem Lüfter wird der Lüfter somit sicher an dem Gehäuseteil gehalten, ohne dass dabei eine starre mechanische Verbindung zwischen dem Lüfter und dem Gehäuseteil hergestellt wird. Auf diesem Wege wird die Schwingungsübertragung von dem Lüfter zu dem Gehäuseteil und somit auch eine Körperschallübertragung reduziert.

Die beschriebene Lüfteranordnung eignet sich insbesondere zur Kühlung leistungsfähiger Prozessoren eines Computersystems.

Weitere Einzelheiten und Ausgestaltungen der Erfindung sind in den Unteransprüchen angegeben.

Die Erfindung wird nachfolgend an Ausführungsbeispielen anhand von Zeichnungen näher erläutert. In den Zeichnungen zeigen:
Figur 1 eine Lüfteranordnung gemäß einer ersten Ausgestaltung der Erfindung,
Figur 2 eine Detailansicht eines Dämpfungselementes gemäß einer Ausgestaltung der Erfindung,
Figur 3 einen Querschnitt durch die Lüfteranordnung gemäß der ersten Ausgestaltung der Erfindung,
Figur 4 eine vergrößerte Darstellung einer Schraube gemäß der ersten Ausgestaltung der Erfindung,
Figur 5 eine Lüfteranordnung gemäß einer zweiten Ausgestaltung der Erfindung,
Figur 6 eine vergrößerte Darstellung eines Spreizniets gemäß der zweiten Ausgestaltung der Erfindung, und
Figur 7 einen vergrößerten Querschnitt durch die Lüfteranordnung gemäß der zweiten Ausgestaltung der Erfindung.

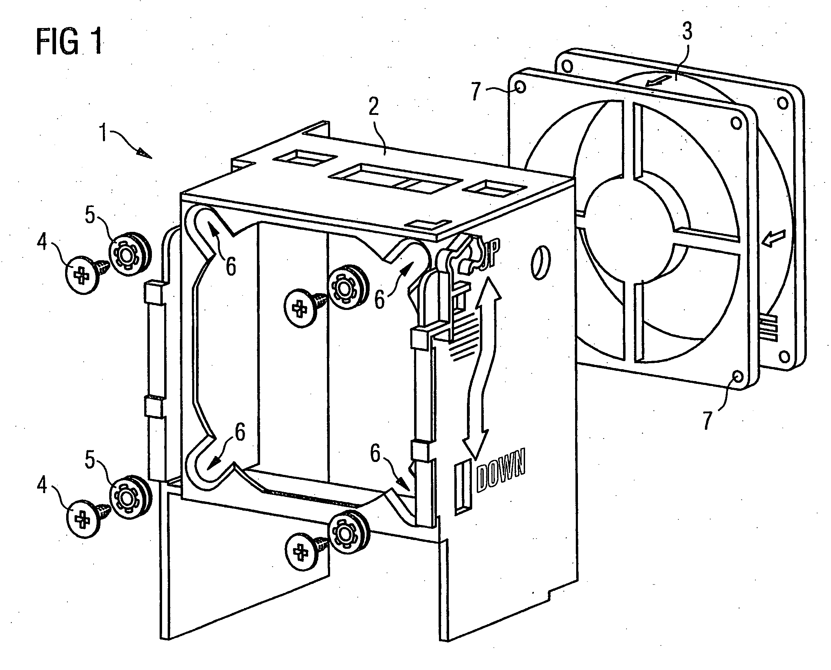

Figur 1 zeigt eine Lüfteranordnung 1, bestehend aus einem Gehäuseteil 2 und einem Lüfter 3. Der Lüfter 3 ist mit Hilfe von Schrauben 4 und Dämpfungselementen 5 an dem Gehäuseteil 2 befestigbar. Dazu werden die Dämpfungselemente 5 zunächst in Aussparungen 6 des Gehäuseteils 2 eingeführt, bevor Schrauben durch die Dämpfungselemente 5 durchgeführt werden und in Befestigungsöffnungen 7 des Lüfters 3 eingeschraubt werden.

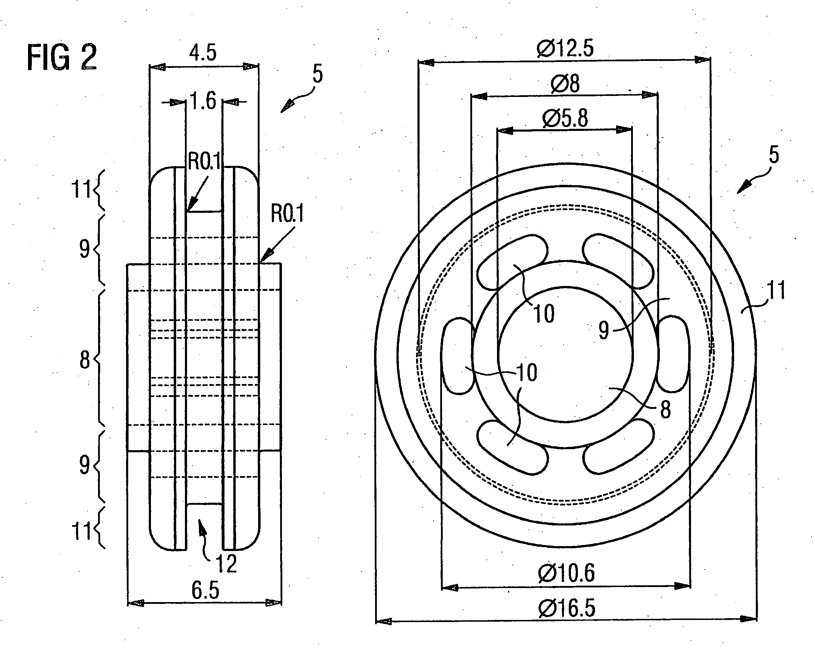

Figur 2 zeigt eine Detailaufnahme der Dämpfungselemente 5 im Längs- und Querschnitt. Die Dämpfungselemente 5 besitzen eine zentrale Öffnung 8, mit deren Hilfe das Dämpfungselement 5 an dem Lüfter 3 befestigbar ist. In einem Zwischenbereich 9 besitzt das Dämpfungselement 5 sechs drehsymmetrisch angeordnete Aussparungen 10. In einem Randbereich 11 ist zusätzlich eine umlaufende Nut 12 eingearbeitet, die zur Befestigung des Dämpfungselementes 5 an dem Gehäuseteil 2 dient.

Selbstverständlich kann auch eine umgekehrte Befestigung mit Hilfe der Dämpfungselemente 5 bewirkt werden. Beispielsweise könnte der Lüfter 3 Aussparungen 6 aufweisen, in die die Dämpfungselemente 5 eingepasst werden, sodass der Lüfter 3 mit den Dämpfungselementen 5 dann mittels Schrauben 4 an einem Gehäuseteil 2 befestigbar wäre.

Durch die zusätzlichen Aussparungen 10 wird die Verformbarkeit und somit die Dämpfung der Dämpfungselemente 10 sowohl in radialer als auch axialer Richtung verbessert. Dabei kann das Verhältnis von Aussparungen 10 und den verbleibenden Verbindungselementen zwischen der zentralen Öffnung 10 und dem Randbereich 11 entsprechend der Anforderungen eingestellt werden, ohne dass ein Wechsel des verwendeten Materials nötig wäre. Im Ausführungsbeispiel ist das Dämpfungselement 5 aus Ethylen-Propylen-Dein-Kautschuk gefertigt.

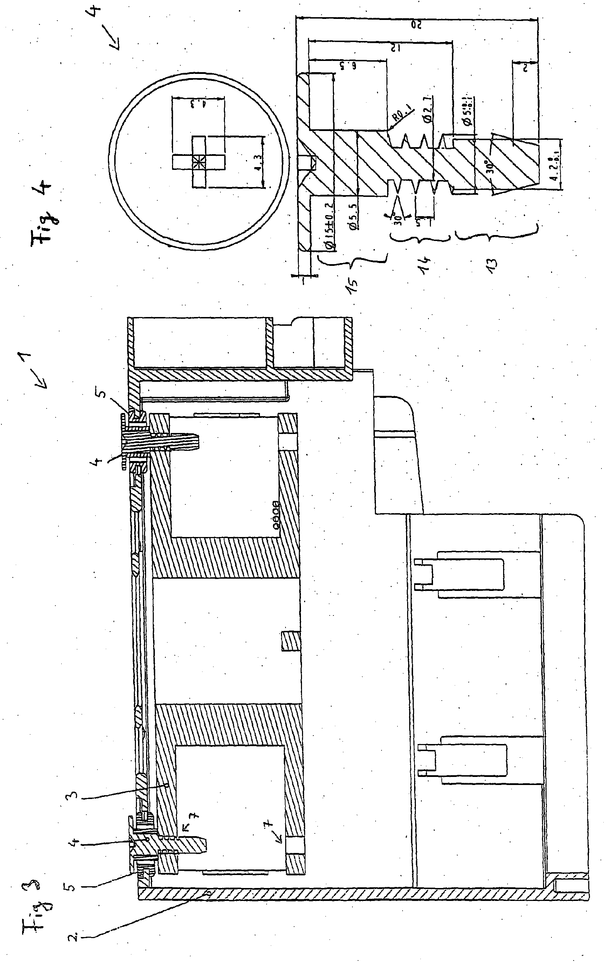

Figur 3 zeigt einen Querschnitt durch die Lüfteranordnung 1. Zwei Schrauben 4 halten den Lüfter 3 an Befestigungsöffnungen 7. Die Schrauben 4 sind in Dämpfungselementen 5 in dem Gehäuseteil 2 gelagert. Durch die spezielle Gestaltung der Schrauben 4 und des Dämpfungselementes 5 wird ein direkter Kontakt zwischen dem Lüfter 3 und dem Gehäuseteil 2 vermieden, sodass keine direkte Schall- oder Vibrationsübertragung stattfindet.

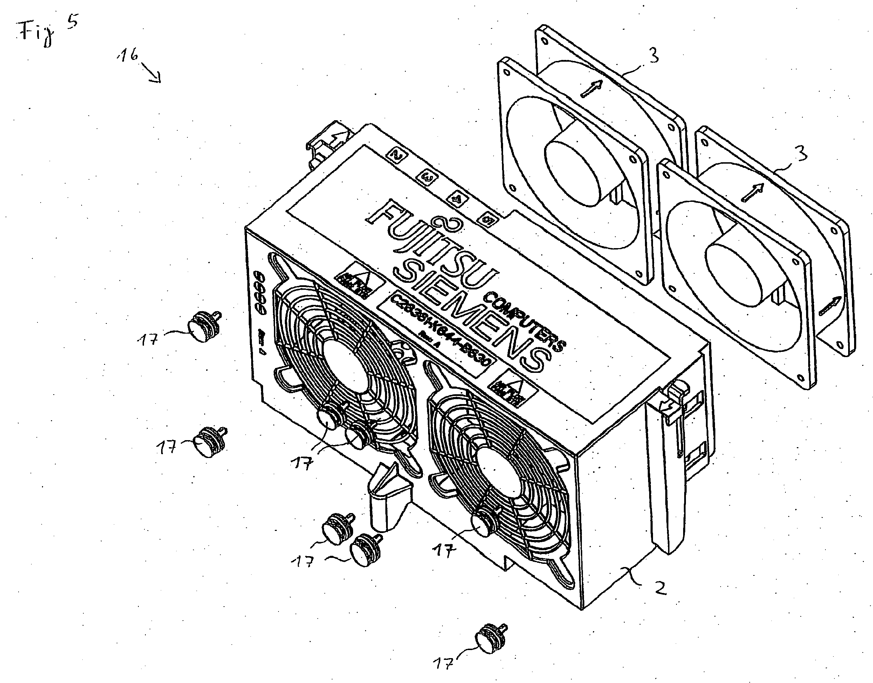

Figur 4 zeigt eine vergrößerte Darstellung der Schraube 4, die aus Metall oder auch aus Kunststoff gefertigt sein kann. Die Schraube 4 weist einen Führungsbereich 13, einen Gewindebereich 14 und einen Haltebereich 15 auf. Durch den Führungsbereich 13 kann die Schraube 4 verhältnismäßig einfach gerade in das Dämpfungselement 5 eingeführt werden. Die konisch zulaufende Spitze erleichtert es zudem, die zentrale Öffnung 8 sicher zu treffen. Die daraus resultierende senkrechte Einbringung der Schraube 4 verhindert eine mögliche Beschädigung des Dämpfungselementes 5 und sichert so die korrekte Funktion der Lüfteranordnung 1. Eine Montage der Lüfteranordnung 1 ist so selbst bei begrenzter Sicht, beispielsweise in engen Gehäusen eines Computersystems, möglich.

Figur 5 zeigt eine Lüfteranordnung 16 gemäß einer zweiten Ausgestaltung der Erfindung. Die Lüfteranordnung 16 weist zwei Lüfter 3 in einem gemeinsamen Gehäuseteil 2 auf. Die Lüfter 3 werden durch die Verwendung von Spreiznieten 17 an dem Gehäuseteil 2 befestigt.

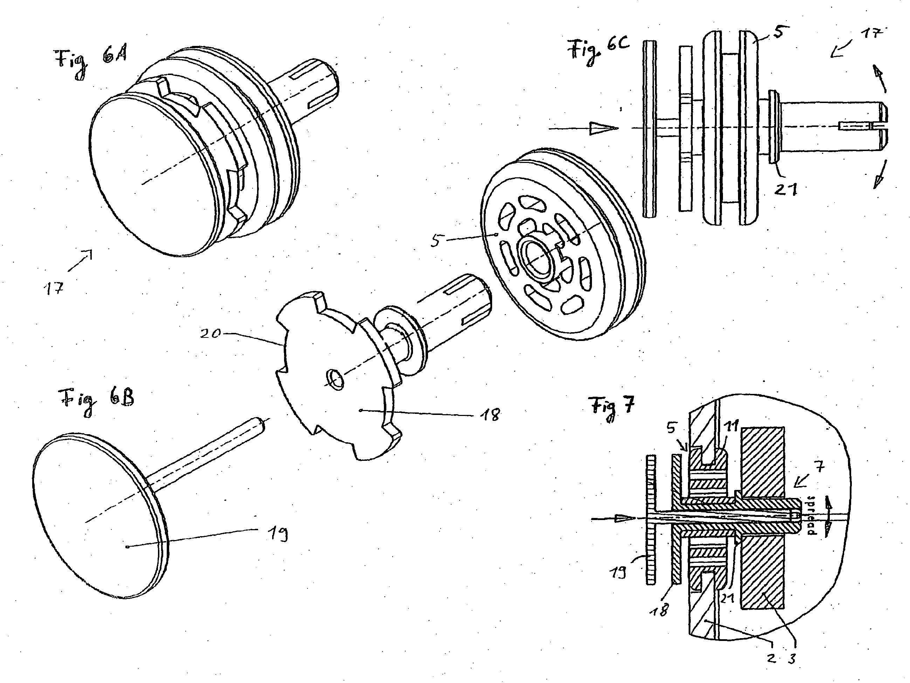

Die Figuren 6A bis 6C zeigen vergrößerte Darstellungen des Spreizniets 17. In der in Figur 6B dargestellten Explosionszeichnung ist zu erkennen, dass der Spreizniet 17 aus einer Lagerbuchse 18 und einem Dorn 19 besteht. Durch Einführen des Dorns 19 werden Teile der Lagerbuchse 18 gespreizt, wie dies in der Figur 6C durch zwei Pfeile angedeutet ist. Die Lagerbuchse 18 weist Aussparungen 20 in einem Kopfbereich auf, die auch eine werkzeugfreie Demontage des Dorns 19 und somit der Spreizniete 17 ermöglichen. Des Weiteren stellt ein umlaufender Bund 21 eine Beabstandung des Dämpfungselementes 5 von der Befestigungsöffnung 7 sicher. Um die Dämpfungseigenschaften des in Figur 6B dargestellten Dämpfungselementes 5 weiter zu verbessern, sind mehrere Reihen von radial versetzen Aussparungen 10 in dem Dämpfungselement 5 vorhanden.

Figur 7 zeigt einen vergrößerten Querschnitt durch die Lüfteranordnung 16 im Bereich einer Spreizniete 17. Die Spreizniete 17 ist in der Figur 7 im noch nicht gespreizten Zustand dargestellt. Durch den umlaufenden Bund 21 der Lagerbuchse 18 wird ein direkter Kontakt zwischen dem Lüfter 3 und dem Randbereich 11 des Dämpfungselementes 5 vermieden. Dadurch werden die maximalen Dämpfungseigenschaften des Dämpfungselementes 5 sowohl in axialer als auch in radialer Richtung bewahrt. Durch einfaches Eindrücken des Dornes 19 in Pfeilrichtung spreizt sich ein Bereich der Lagerbuchse 18 und hält somit den Lüfter 3 sicher an dem Gehäuseteil 2 fest.

In einer bevorzugten Ausgestaltung der Erfindung sind die Lagerbuchse 18 und das Dämpfungselement 5 einstückig hergestellt oder vormontiert, sodass eine einfache und komplett werkzeugfreie Montage eines Lüfters 3 in dem Gehäuseteil 2 möglich ist.

Die erfindungsgemäße Lüfteranordnung eignet sich insbesondere zur Kühlung von Prozessoren, Netzteilen und anderen Komponenten eines Computersystems, wie beispielsweise Grafikkarten. Nichtsdestotrotz eignet sich eine erfindungsgemäße Kühlanordnung auch zur Befestigung anderer schwingender Einzelteile in anderen Vorrichtungen.

### Bezugszeichenliste

- 1: Lüfteranordnung
- 2: Gehäuseteil
- 3: Lüfter
- 4: Schraube
- 5: Dämpfungselement
- 6: Aussparung
- 7: Befestigungsöffnung
- 8: zentrale Öffnung
- 9: Zwischenbereich
- 10: Aussparung
- 11: Randbereich
- 12: Nut
- 13: Führungsbereich
- 14: Gewindebereich
- 15: Haltebereich
- 16: Lüfteranordnung
- 17: Spreizniet
- 18: Spannbuchse
- 19: Dorn
- 20: Aussparung
- 21: Bund

## Patentansprüche

1. Lüfteranordnung (1, 16), aufweisend ein Gehäuseteil (2), wenigstens einen Lüfter (3) und wenigstens ein Dämpfungselement (5) bestehend aus einem elastischen Material, wobei das Dämpfungselement (5) eine zentrale Öffnung (8) zur Befestigung des Dämpfungselementes (5) an Befestigungsöffnungen (7) des Lüfters (3) oder des Gehäuseteils (2) aufweist,
**dadurch gekennzeichnet, dass**
- das Dämpfungselement (5) Aussparungen (10) in einem Zwischenbereich (9) zwischen der zentralen Öffnung (8) und einem Randbereich (11) des Dämpfungselementes (5) zur Erhöhung der Verformbarkeit in sowohl axialer als auch radialer Richtung aufweist, um die Schwingungsübertragung von dem Lüfter (3) zu dem Gehäuseteil (2) zu dämpfen.

2. Lüfteranordnung (1, 16) nach Anspruch 1,
**dadurch gekennzeichnet, dass**
die Aussparungen (10) des Dämpfungselementes (5) symmetrisch um die zentrale Öffnung (8) angeordnet sind.

3. Lüfteranordnung (1, 16) nach Anspruch 1,
**dadurch gekennzeichnet, dass**
die Aussparungen (10) des Dämpfungselementes (5) mehrreihig um die zentrale Öffnung (8) angeordnet sind.

4. Lüfteranordnung (1, 16) nach einem der Ansprüche 1 bis 3,
**dadurch gekennzeichnet, dass**
das Dämpfungselement (5) im Randbereich (11) eine umlaufende Nut (12) aufweist, durch die das Dämpfungselement (5) an dem Gehäuseteil (2) oder dem Lüfter (3) befestigt ist.

5. Lüfteranordnung (1, 16) nach einem der Ansprüche 1 bis 4,
**dadurch gekennzeichnet, dass**
die Lüfteranordnung (1) zur Kühlung eines Prozessors oder einer Speicherbaugruppe oder einer Kombination davon eingerichtet ist.

6. Lüfteranordnung (1, 16) nach einem der Ansprüche 1 bis 5,
**dadurch gekennzeichnet, dass**
das Dämpfungselement (5) aus Ethylen-Propylen-Dein-Kautschuk gefertigt ist.

7. Lüfteranordnung (1, 16) nach einem der Ansprüche 1 bis 6,
**dadurch gekennzeichnet, dass**
das Dämpfungselement (5) als Muffe ausgeführt und mit Hilfe eines durch die zentrale Öffnung (8) geführten Befestigungselementes (4, 17) an Befestigungsöffnungen (7) des Lüfters (3) oder des Gehäuseteils (2) befestigt ist.

8. Lüfteranordnung (1, 16) nach Anspruch 7, **dadurch gekennzeichnet, dass**
das Befestigungselement (4, 17) aus Kunststoff gefertigt ist.

9. Lüfteranordnung (1) nach Anspruch 7 oder 8, **dadurch gekennzeichnet, dass**
das Befestigungselement (4, 17) eine Schraube (4) umfasst.

10. Lüfteranordnung (1) nach Anspruch 9, **dadurch gekennzeichnet, dass**
die Schraube (4) einen gewindefreien Führungsbereich (13) aufweist, der die Schraube (4) beim Einführen in der zentralen Öffnung (8) führt.

11. Lüfteranordnung (16) nach Anspruch 7 oder 8, **dadurch gekennzeichnet, dass**
das Befestigungselement (4, 17) einen Spreizniet (17) mit einer Spannbuchse (18) und einem Dorn (19) umfasst.

12. Lüfteranordnung (16) nach Anspruch 11, **dadurch gekennzeichnet, dass**
die Spannbuchse (18) und das Dämpfungselement (5) einstückig gefertigt sind.

13. Lüfteranordnung (16) nach Anspruch 11 oder 12, **dadurch gekennzeichnet, dass**
die Spannbuchse (18) einen umlaufenden Bund (21) aufweist, der einen direkten Kontakt zwischen dem Randbereich (11) des Dämpfungselementes (5) und dem Lüfter (3) oder dem Gehäuseteil (2) verhindert.

14. Lüfteranordnung (16) nach einem der Ansprüche 11 bis 13, **dadurch gekennzeichnet, dass**
der Lüfter (3) werkzeugfrei in dem Gehäuseteil (2) montierbar oder demontierbar ist.

15. Lüfteranordnung (1, 16) nach Anspruch 7 oder 8, **dadurch gekennzeichnet, dass**
das Befestigungselement (4, 17) ein an den Lüfter (3) oder das Gehäuseteil (2) angeflanschtes Verbindungselement umfasst.
